**Europäisches Patentamt**

**European Patent Office**

**Office européen des brevets**

(19)

(11) Veröffentlichungsnummer : **0 355 329 B1**

(12)

# EUROPÄISCHE PATENTSCHRIFT

(45) Veröffentlichungstag der Patentschrift :
**02.09.92 Patentblatt 92/36**

(51) Int. Cl.$^5$ : **H03H 11/20, H03K 5/13**

(21) Anmeldenummer : **89111948.9**

(22) Anmeldetag : **30.06.89**

(54) **Schaltungsanordnung zur Phasenverschiebung.**

(30) Priorität : **25.08.88 DE 3828840**

(43) Veröffentlichungstag der Anmeldung :
**28.02.90 Patentblatt 90/09**

(45) Bekanntmachung des Hinweises auf die
Patenterteilung :
**02.09.92 Patentblatt 92/36**

(84) Benannte Vertragsstaaten :
**BE DE ES FR GB IT NL SE**

(56) Entgegenhaltungen :
**EP-A- 0 054 323**
**EP-A- 0 226 546**
**EP-A- 0 247 871**

(73) Patentinhaber : **ANT Nachrichtentechnik
GmbH
Gerberstrasse 33
W-7150 Backnang (DE)**

(72) Erfinder : **Sperlich, Josef, Dipl.-Ing.
Kelterweg 52
W-7150 Backnang (DE)**
Erfinder : **Thier, Heinz, Dipl.-Ing.
Kohlhauweg 16
W-7157 Murrhardt (DE)**

EP 0 355 329 B1

## Beschreibung

Die vorliegende Erfindung betrifft eine Schaltungsanordnung zum Verschieben der Phase eines Signals in Abhängigkeit von einem Steuersignal, das die Phase angibt, um welches das Signal versetzt werden soll, wobei Schaltungsmittel vorgesehen sind, die der jeweils durch das Steuersignal repräsentierten Phase zwei orthogonale kartesische Signalkomponenten zuordnen, von denen eine Signalkomponente als Steuersignal für eine ihr proportionale Verstärkung einer von zwei um 90° gegeneinander versetzten Signalanteilen dient, in die das phasenzuverschiebende Signal aufgeteilt ist, und von denen die andere Signalkomponente als Steuersignal für eine ihr proportionale Verstärkung des anderen der beiden Signalanteile dient, und ein Addierer die beiden verstärkten Signalanteile zusammenfaßt.

Eine derartige Schaltungsanordnung ist aus der EP-A- 0 247 871 bekannt. Hierbei leitet eine aufwendige Analogschaltung von dem die Phase repräsentierenden Steuersignal die orthogonalen Signalkomponenten ab. Diese Schaltungsanordnung kann lediglich im Bereich von + 90° bis - 90° die Phase eines Signals verändern.

Eine ähnliche Phasenschieberschaltung geht aus der EP-A- 0 54 323 hervor. Die Ableitung der orthogonalen Signalkomponenten von dem die Phase repräsentierenden Signal geschieht hier mit einer aufwendigen analogen Transistorschaltung. Die Bewertung der Signalanteile mit den aus der Phase gewonnenen Signalkomponenten erfolgt mittels Multiplizierern.

Die EP-A- 0 226 546 offenbart eine Schaltungsanordnung zur Detektion von Phasenablagen. Dabei sind alle möglichen Phasenzustände eines Vergleichssignals in orthogonale Signalkomponenten zerlegt und diese Signalkomponenten in einem Speicher (ROM) abgelegt.

Der Erfindung liegt nun die Aufgabe zugrunde, eine Schaltungsanordnung der eingangs genannten Art anzugeben, die mit möglichst wenig aufwendigen Mittel eine unbegrenzte Phasenverschiebung eines Signals bewirken kann.

Erfindungsgemäß wird diese Aufgabe durch die Merkmale des Anspruchs 1 gelöst. Zweckmäßige Ausführungen der Erfindung gehen aus den Unteransprüchen hervor.

Anhand zweier in der Zeichnung dargestellter Ausführungsbeispiele wird nachfolgend die Erfindung näher erläutert.

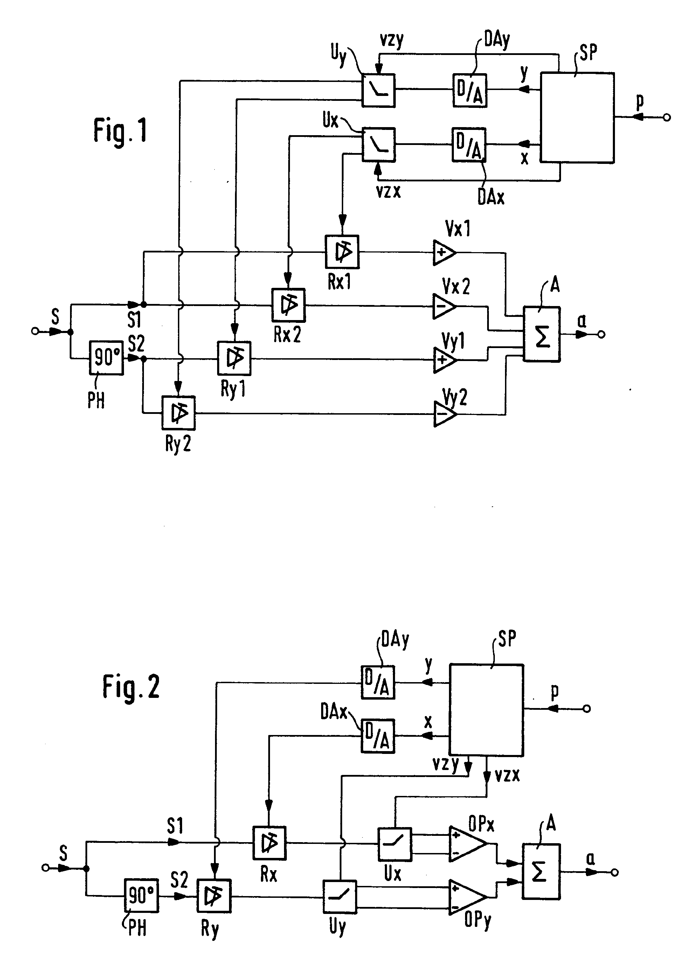

Figur 1 und 2 zeigen zwei verschiedene Phasenschieberschaltungen.

Bei den in den Figuren 1 und 2 gezeigten Phasenschieberschaltungen wird das in seiner Phase zu verändernde Signal S zunächst aufgeteilt in zwei Signalanteile S1 und S2, von denen der Signalanteil S2 gegenüber dem Signalanteil S1 mittels eines Phasengliedes PH um 90° phasenversetzt ist.

Am Eingang eines Speichers SP liegt ein Steuersignal p an, welches diejenige Phase angibt, um die das Signal S phasenverschoben werden soll. Und zwar gibt das Steuersignal p dem Speicher SP die Information über die Phase in digitaler Form an. Jeder möglichen Phase entspricht also ein bestimmtes Digitalwort, und jedem dieser Digitalworte ist eine Adresse im Speicher SP zugeordnet. An jeder zu einer bestimmten Phase gehörenden Adresse sind zwei Signalkomponenten abgespeichert. Es handelt sich dabei um zwei der Phase zugeordnete orthogonale kartesische Signalkomponenten, die aus der Zerlegung eines um diese Phase im Phasenkreis gedrehten Zeigers in seine kartesischen Komponenten hervorgehen.

Gelangt nun ein Steuersignal p mit seiner Phaseninformation in den Speicher SP, so erscheinen an seinen Ausgängen die dieser Phase zugeordneten orthogonalen Signalkomponenten x und y. Die in digitaler Form vorliegenden Signalkomponenten werden von Digital-Analogumsetzern DAx und DAy in entsprechende analoge Signalkomponenten umgewandelt. Neben den orthogonalen kartesischen Signalkomponenten x und y gibt der Speicher SP an zwei weiteren Ausgängen deren Vorzeichen (+, -) vzx und vzy aus.

Gemäß der in Figur 1 dargestellten Phasenschieberschaltung sind für jeden Signalanteil S1 bzw. S2 zwei Regelverstärker Rx1 und Rx2 bzw. Ry1 und Ry2 vorgesehen, deren Verstärkung V auf Werte im Bereich $0 \leqq V \leqq 1$ einstellbar ist. Die Regelverstärker Rx1 und Rx2 für den ersten Signalanteil S1 erhalten als Steuersignal die Signalkomponente x aus dem Speicher SP, und die Regelverstärker Ry1 und Ry2 des um 90° phasenversetzten zweiten Signalanteils S2 erhalten als Steuersignal die Signalkomponente y. Dem einen Regelverstärker Rx1 für den ersten Signalanteil S1 ist ein nichtinvertierender Verstärker Vx1 und dem anderen Regelverstärker Rx2 ist ein invertierender Verstärker Vx2 nachgeschaltet.

Ebenso ist für den zweiten Signalanteil S2 dem einen Regelverstärker Ry1 ein nichtinvertierender Verstärker Vy1 und dem anderen Regelverstärker Ry2 ein invertierender Verstärker Vy2 nachgeschaltet. Alle vier Verstärker Vx1, Vx2, Vy1 und Vy2 haben bis auf das Vorzeichen den gleichen Verstärkungsfaktor. Ihre Ausgänge führen zu einem Addierer A. Hat jeweils eine vom Speicher SP ausgegebene Signalkomponente x bzw. y ein positives Vorzeichen, so veranlaßt die das Vorzeichen angebende Steuergröße vzx bzw. vzy den betreffenden Umschalter Ux bzw. Uy die ihm zugeordnete Signalkomponente x bzw. y auf den Regelverstärker Rx1 bzw. Ry1 mit dem nachfolgenden nichtinvertierenden Verstärker Vx1 bzw. Vy1 umzuschalten. Wogegen bei negativem Vorzeichen einer Signalkomponente x bzw. y der Umschalter Ux bzw. Uy die Signalkomponente x bzw.

2

y auf den Regelverstärker Ry2 bzw. Ry2 mit den nachfolgenden invertierenden Verstärker Vx2 bzw. Vy2 schaltet. Von den zwei für jeden Signalanteil S1 bzw. S2 zur Verfügung stehenden Regelverstärkern Rx1 und Rx2 bzw. Ry1 und Ry2 erhält also immer nur einer eine Signalkomponente x bzw. y als Steuersignal. Der jeweils nicht angesteuerte Regelverstärker wird mit der Verstärkung V=0 betrieben, d.h. er stellt für den ihm zugeordneten Signalanteil S1 bzw. S2 einen Leerlauf dar.

Die beiden Signalanteile S1 und S2 werden nach der vorangehend beschriebenen, den Signalkomponenten x und y proportionalen Verstärkung durch den Addierer A zu einem Ausgangssignal a wieder zusammengefaßt, welches nun gegenüber dem Eingangssignal s um die durch das Steuersignal p vorgegebene Phase verschoben ist.

Bei einer in Figur 2 dargestellten Ausführungsform eines Phasenschiebers ist für jeden Signalanteil S1 und S2 nur ein Regelverstärker Rx, Ry vorgesehen, von denen der eine die Signalkomponente x und der andere die Signalkomponente y als Steuersignal erhält. Dem Regelverstärker Rx ist ein Operationsverstärker OPx und dem Regelverstärker Ry ein Operationsverstärker OPy nachgeschaltet. Beide auf die gleiche Verstärkung eingestellten Operationsverstärker OPx und OPy weisen einen invertierenden und einen nichtinvertierenden Eingang auf und sind mit ihren Ausgängen an den Addierer A angeschlossen. Der der Signalkomponente x zugeordnete Umschalter Ux schaltet in Abhängigkeit von ihrem Vorzeichen vzx den im Regelverstärker Rx proportional zur Signalkomponente x verstärkten Signalanteil S1 auf den invertierenden oder den nichtinvertierenden Eingang des Operationsverstärkers OPx. In gleicher Weise wird der aus dem Regelverstärker Ry austretende Signalanteil S2 je nach den Vorzeichen vzy der Signalkomponente y entweder auf den invertierenden oder den nichtinvertierenden Eingang des Operationsverstärkers OPy geschaltet.

## Patentansprüche

1) Schaltungsanordnung zum Verschieben der Phase eines Signals in Abhängigkeit von einem Steuersignal (p), das die Phase angibt, um welches das Signal (S) versetzt werden soll, wobei Schaltungsmittel (SP) vorgesehen sind, die der jeweils durch das Steuersignal (p) repräsentierten Phase zwei orthogonale kartesische Signalkomponenten (x, y) zuordnen, von denen eine Signalkomponente als Steuersignal für eine ihr proportionale Verstärkung einer von zwei um 90° gegeneinander versetzten Signalanteilen (S1, S2) dient, in die das phasenzuverschiebende Signal (S) aufgeteilt ist, und von denen die andere Signalkomponente als Steuersignal für eine ihr proportionale Verstärkung des anderen der beiden Signalanteile (S1, S2) dient, und ein Addierer (A) die beiden verstärkten Signalanteile zusammenfaßt, dadurch gekennzeichnet, daß jeder durch das Steuersignal (p) repräsentierten Phase eine Adresse in einem Speicher (SP) zugeordnet ist, bei der zwei der jeweiligen Phase zugeordnete orthogonale kartesische Signalkomponenten (x, y) abgelegt sind, und daß für jede der zwei orthogonalen Signalkomponenten (x, y) ein Umschalter (Ux, Uy) vorhanden ist, der bei negativem Vorzeichen der Signalkomponente veranlaßt, daß der ihr zugeordnete verstärkte Signalanteil über einen Inverter (Vx2, Vy2, OPx, OPy) zum Addierer (A) gelangt.

2) Schaltungsanordnung nach Anspruch 1, dadurch gekennzeichnet, daß für jeden der zwei Signalanteile (S1, S2) zwei Regelverstärker (Rx1, Rx2, Ry1, Ry2) vorhanden sind, daß einem der beiden Regelverstärker (Rx1, Rx2, Ry1, Ry2) ein invertierender Verstärker (Vx2, Vy2) und dem anderen Regelverstärker ein nichtinvertierender Verstärker (Vx1, Vy1) nachgeschaltet ist, und daß der der jeweiligen Signalkomponente (x, y) zugeordnete Umschalter (Ux, Uy) diese je nach ihrem Vorzeichen (vzx, vzy) als Steuersignal entweder auf den Regelverstärker (Rx2, Ry2) mit nachfolgendem invertierenden Verstärker (Vx2, Vy2) oder auf den Regelverstärker (Rx1, Ry1) mit nachfolgendem nichtinvertierenden Verstärker (Vx1, Vy1) schaltet, wobei der jeweils nicht angesteuerte Regelverstärker für den Signalanteil einen Leerlauf darstellt.

3) Schaltungsanordnung nach Anspruch 1, dadurch gekennzeichnet, daß für jeden der zwei Signalanteile (S1, S2) ein Regelverstärker (Rx, Ry) vorhanden ist, und daß je nach dem Vorzeichen (vzx, vzy) der den Regelverstärker (Rx, Ry) steuernden Signalkomponente (x, y) der ihr zugeordnete Umschalter (Ux, Uy) den Ausgang des Regelverstärkers (Rx, Ry) entweder auf den invertierenden oder auf den nichtinvertierenden Eingang eines Operationsverstärkers (OPx, OPy) schaltet.

## Revendications

1. Circuit de décalage de phase d'un signal en fonction d'un signal de commande (p) qui indique la différence de phase dont il faut décaler le signal (S), circuit dans lequel sont prévus des moyens de commutation (SP) qui, au décalage de phase représenté par le signal de commande (p), font correspondre deux composantes cartésiennes orthogonales (x, y) du signal de décalage de phase dont l'une des

EP 0 355 329 B1

composantes du signal de décalage de phase sert comme signal de commande pour une amplification, qui lui est proportionnelle, de l'une des deux composantes (S1, S2) du signal de phase qui font entre elles un angle de 90°, en lesquelles est décomposé le signal (S) dont il faut décaler la phase, et dont l'autre composante du signal de décalage de phase sert comme signal de commande pour une amplification, qui lui est proportionnelle, de l'autre des deux composantes (S1, S2) du signal de phase, et circuit dans lequel un additionneur (A) regroupe les deux composantes, amplifiées, du signal de phase, circuit caractérisé par le fait qu'à chaque décalage de phase, représenté par le signal de commande (p), correspond, dans une mémoire (SP), une adresse à laquelle sont inscrites deux composantes cartésiennes ortogonales (x, y) correspondant à la phase respective, du signal de décalage de phase, et par le fait que pour chacune des deux composantes orthogonales (x, y) du signal de décalage de phase, est prévu un commutateur (Ux, Uy) qui, en présence d'un signe négatif de la composante du signal de décalage de phase, fait en sorte que la composante du signal de phase correspondante, amplifiée, parvienne à l'additionneur (A) par l'intermédiaire d'un inverseur (Vx2, Vy2, OPx, OPy).

2. Circuit selon la revendication 1, caractérisé par le fait que pour chacune des deux composantes (S1, S2) du signal de phase existent deux amplificateurs de réglage (Rx1, Rx2, Ry1, Ry2) par le fait qu'en aval de l'un des deux amplificateurs de réglage (Rx1, Rx2, Ry1, Ry2) est mis en circuit un amplificateur inverseur (Vx2, Vy2) et qu'en aval de l'autre amplificateur de réglage est mis en circuit un amplificateur non inverseur (Vx1, Vy1), et par le fait que le commutateur (Ux, Uy) correspondant à la composante respective (x, y) du signal de décalage de phase commute cette composante, selon chaque fois son signe (vzx, vzy) comme signal de commande, soit sur l'amplidicateur de réglage (Rx2, Ry2) en aval duquel est mis en circuit l'amplificateur inverseur (Vx2, Vy2) soit sur l'amplificateur de réglage (Rx1, Ry1) en aval duquel est mis en circuit l'amplificateur non inverseur (Vx1, Vy1), étant précisé que l'amplificateur de réglage qui n'est chaque fois pas utilisé représente un passage sans suite pour la composante du signal de phase.

3. Circuit selon la revendication 1, caractérisé par le fait que pour chacune des deux composantes S1, S2) du signal de phase existe un amplificateur de réglage (Rx, Ry) et par le fait que selon chaque fois le signe (vzx, vzy) de la composante (x, y) du signal de décalage de phase qui commande l'amplificateur de réglage (Rx, Ry), le commutateur (Ux, Uy) qui lui correspond commute la sortie de l'amplificateur de réglage (Rx, Ry) soit sur l'entrée inverseuse, soit sur l'entrée non inverseuse d'un amplificateur opérationnel (OPx, OPy).

**Claims**

1. Circuit arrangement for the displacement of the phase of a signal in dependence on a control signal (p), which indicates the phase through which the signal (S) shall be displaced, wherein circuit means (SP) are provided, which assign two orthogonal Cartesian signal components (x, y) to the phase respectively represented by the control signal (p), of which one signal component serves as control signal for an amplification proportional thereto of one of two signal portions (S1, S2), which are each displaced relative to the other through 90° and in which the signal S to be displaced in phase is split up, and of which the other signal component serves as control signal for an amplification proportional thereto of the other of the two signal portions (S1, S2) and an adder (A) combines both the amplified signal portions, characterised thereby, that each phase represented by the control signal (p), is assigned an address in a storage device (sp), at which two orthogonal Cartesian signal components (x, y) assigned to the respective phase are filed, and that a change-over switch (Ux, Uy), which in the case of a negative sign of the signal components causes the amplified signal portion assigned thereto to get to the adder (A) by way of an inverter (Vx2, Vy2, OPx, OPy), is present for each of the two orthogonal signal components (x, y).

2. Circuit arrangement according to claim 1, characterised thereby, that two regulating amplifiers (Rx1, Rx2, Ry1, Ry2) are present for each of the two signal portions (S1, S2), that an inverting amplifier (Vx2, Vy2) is connected behind one of both the regulating amplifiers (Rx1, Rx2, Ry1, Ry2) and a non-inverting amplifier (Vx1, Vy1) is connected behind the other regulating amplifier and that the change-over switch (Ux, Uy), which is assigned to the respective signal component (x, y), switches this according to its respective sign (vzx, vzy) as control signal either to the regulating amplifier (Rx2, Ry2) with following inverting amplifier (Vx2, Vy2) or to the regulating amplifier (Rx1, Ry1) with following non-inverting amplifier (Vx1, Vy1), wherein the regulating amplifier, that is respectively not driven, represents an idling for the signal portion.

4

3. Circuit arrangement according to claim 1, characterised thereby, that a regulating amplifier (Rx, Ry) is present for each of the two signal portions (S1, S2) and that, in accordance with the respective sign (vzx, vzy) of the signal component (x, y) controlling the regulating amplifier (Rx, Ry), the change-over switch (Ux, Uy), which is assigned thereto, switches the output of the regulating amplifier (Rx, Ry) either to the inverting or to the non-inverting input of an operational amplifier (OPx, OPy).

Fig.1

Fig.2